Europäisches Patentamt

European Patent Office

Office européen des brevets

(11) Veröffentlichungsnummer: **0 012 220**
A1

# EUROPÄISCHE PATENTANMELDUNG

(21) Anmeldenummer: 79104373.0

(22) Anmeldetag: 08.11.79

(51) Int. Cl.³: **H 01 L 29/91**

(30) Priorität: 11.12.78 US 968052

(43) Veröffentlichungstag der Anmeldung: 25.06.80
Patentblatt 80/13

(84) Benannte Vertragsstaaten: **DE FR GB**

(71) Anmelder: **International Business Machines
Corporation, Armonk, N.Y. 10504 (US)**

(72) Erfinder: **Dreves, Richard Ford, Plains Road RFD No. 2,
Westford, Vt. 05494 (US)**
Erfinder: **Fresia, John Frank, Dorset Street Ext.,
Shelburne, Vt. 05482 (US)**
Erfinder: **Kim, Sang Uk, RD 2 Rustic Drive, Essex
Junction, Vt. 05452 (US)**
Erfinder: **Lajza, Jr. John James, 14 South Hill Drive,
Essex Junction, Vt. 05452 (US)**

(74) Vertreter: **Gaugel, Heinz, Dipl.-Ing., Schönaicher
Strasse 220, D-7030 Böblingen (DE)**

(54) **Verfahren zur Herstellung eines Schottky-Kontakts mit selbstjustierter Schutzringzone.**

(57) Ein Schottky-Kontakt (24) mit ihn umgebender Schutzringzone (23) wird platzsparend durch ein selbstjustierendes
Maskierungsverfahren hergestellt.

Dabei wird die Oberfläche (12) eines Halbleiterkörpers
(10) eine erste (13) und darüber eine zweite Maskierungsschicht (14) aufgebracht. Die erste Maskierungsschicht (13)
weist eine größere Ätzrate auf als die zweite Maskierungsschicht (14), so daß beim Ätzen des Maskenfensters zum
Aufbringen des Schottky-Kontakts (24) die zweite Maskierungsschicht (14) in der ersten Maskierungsschicht (13) unterätzt wird. Beim Aufbringen des Schottky-Kontakts (24) ist
dieser auf die Ausdehnung des kleineren Maskenfensters in
der zweiten Maskierungsschicht (14) begrenzt. In den freiliegenden, ringförmigen, vom äußeren Rand des Schottky-Kontakts (24) und vom inneren Rand des größeren Maskenfensters in der ersten Maskierungsschicht (13) begrenzten
Oberflächenbereich (12b) des Halbleiterkörpers (10) wird die
Schutzringzone (23) eindiffundiert. Dabei bilden die erste
Maskierungsschicht (13) und der Schottky-Kontakt selbst
die Diffusionsmaske.

Verfahren zur Herstellung eines Schottky-Kontakts mit selbstjustierter Schutzringzone

Die Erfindung betrifft ein Verfahren zur Herstellung eines
Schottky-Kontakts mit selbstjustierter Schutzringzone, die
den Schottky-Kontakt umgibt und in die Oberfläche des diesen
tragenden, dem entgegengesetzten Leitungstyp angehörenden
Halbleiterkörpers eingebracht wird.

Bringt man bestimmte Metalle in innigen Kontakt mit einer
Halbleiteroberfläche, so lassen sich an der Metall-Halbleitergrenzfläche die einem Halbleiter-Übergang entsprechenden
Gleichrichter-Eigenschaften feststellen. Derartige Grenzflächen sind als Schottky-Kontakte oder Schottky-Dioden bekannt und sie weisen eine Reihe von Eigenschaften auf, die
ihre Anwendung in integrierten Halbleiteranordnungen rechtfertigen.

Neben den üblichen Schottky-Kontakten, die weit verbreitete
Anwendung gefunden haben, sind auch bereits Schottky-Kontakte bekannt, die zusätzlich eine Schutzringzone aufweisen.
Beispielsweise ist aus der US-Patentschrift Nr. 4 063 964
ein Verfahren zur Herstellung eines Schottky-Kontaktes mit
Schutzringzone bekannt, wobei die Schutzringzone durch Ionenimplantation hergestellt wird. Andere Verfahren zur Verwirklichung einer derartigen Schutzringzone sind in den US-Patentschriften Nr. 3 961 350 und 3 616 380 beschrieben.

Diese Schutzringzonen haben in erster Linie die Aufgabe, die
Durchbruchs-Spannungscharakteristiken des Bauelementes zu
verbessern. Die Ursache für das schlechte Durchbruchsverhalten der in üblicher Weise hergestellten Schottky-Kontakte ergibt sich im wesentlichen daraus, daß an den scharfen Kanten der Grenzfläche zwischen Metall und Halbleitermaterial eine hohe elektrische Feldstärke auftritt, die bei Betrieb des Bauelementes in Sperrichtung zu einem Lawinendurchbruch führen kann.

Weitere Methoden zur Verbesserung der Durchbruchsspannungs-
Charakteristik von Schottky-Kontakten sind beispielsweise
den US-Patentschriften 3 763 408 und 3 752 702 zu entnehmen. Diese Methoden bestehen darin, daß eine Unterschneidung am Rande der den Schottky-Kontakt bildenden
Metallschicht eingebracht wird.

Die bekannten Verfahren zur Herstellung von Schottky-Kontakten mit Schutzringzonen sind sehr aufwendig, da das
Einbringen der Schutzringzone besondere, zusätzliche Maßnahmen erfordert. Außerdem ist festzustellen, daß die
Schutzringzone zu einem beträchtlichen Mehraufwand an
Halbleiterfläche für den Schottky-Kontakt führt.

Hier will die Erfindung Abhilfe schaffen. Die Erfindung,
wie sie in den Ansprüchen gekennzeichnet ist, löst die
Aufgabe, ein Verfahren zur Herstellung eines Schottky-Kontakts mit Schutzringzone anzugeben, das relativ einfach
durchzuführen ist und durch selbstjustierendes Einbringen
der Schutzringzone zu einer platzsparenden Halbleiterstruktur führt.

Zusammenfassend kann die Erfindung im wesentlichen darin
gesehen werden, daß von einer Maske mit zur Oberfläche des
Halbleiterkörpers hin ausgeweitetem Maskenfenster Gebrauch
gemacht wird. Ein solches Maskenfenster kann durch Ätzen
einer Doppel-Maskierungsschicht erzielt werden, wobei die
untere, auf der Oberfläche des Halbleiterkörpers aufliegende erste Maskierungsschicht mit einer größeren Ätzrate geätzt wird als die obere zweite Maskierungsschicht.
Durch die unterschiedliche Ätzrate erzielt man ein kleineres Maskenfenster in der zweiten Maskierungsschicht über einem größeren Maskenfenster in der ersten Maskierungsschicht. Durch einen Verdampfungs- oder Zerstäubungsprozeß wird der durch das kleinere Maskenfenster festgelegte Bereich der Oberfläche des Halbleiterkörpers mit einem eine Diffusion von Störstellen verhindernden, einen Schottky-Kontakt bildenden Material beschichtet. Zwischen dem äußeren Rand dieser Schicht und dem inneren Rand des größeren Fensters der ersten Maskierungsschicht entsteht ein ringförmiger Bereich, in dem die Halbleiteroberfläche unbedeckt bleibt. In einem nachfolgenden Diffusionsprozeß wird die auf diesen ringförmigen Bereich begrenzte Schutzringzone in die Oberfläche des Halbleiterkörpers eingebracht, wobei die Schicht im Bereich des zu bildenden Schottky-Kontaktes und die erste Maskierungsschicht als Diffusionsmaske dienen.

Im folgenden wird die Erfindung anhand einer lediglich einen Ausführungsweg darstellenden Zeichnung näher erläutert.

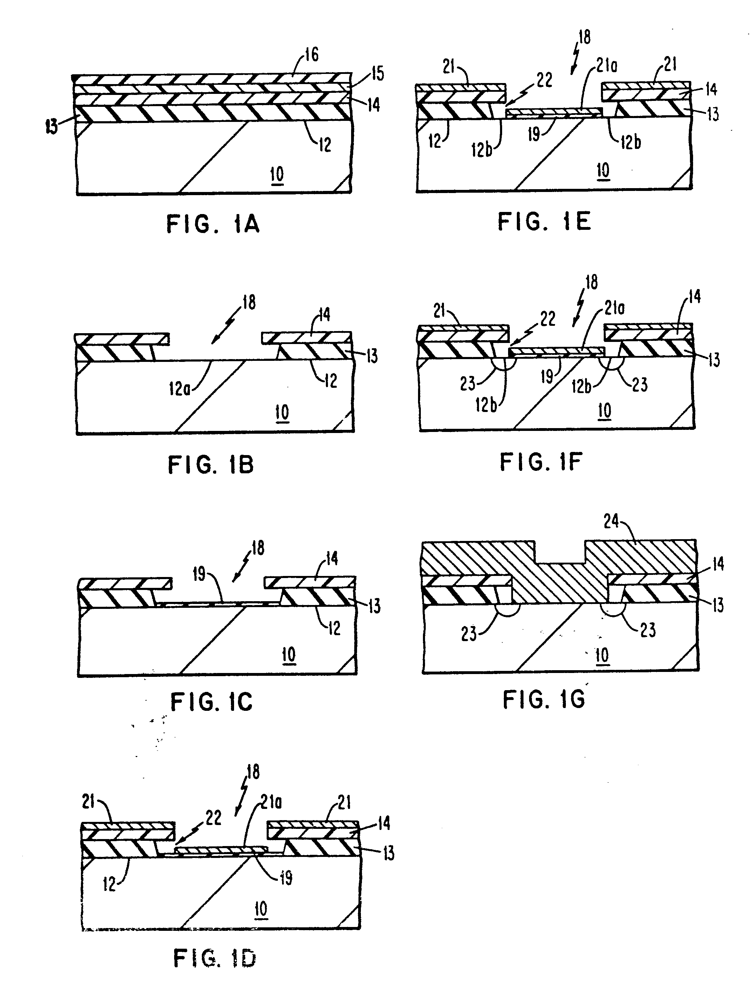

Es zeigen die Fign. 1A bis 1G Schnittansichten eines erfindungsgemäßen Schottky-Kontakes in aufeinanderfolgenden Stufen des Herstellungsverfahrens.

Zunächst sei die Fig. 1A betrachtet. Dargestellt wird ein N-dotierter, als Ausgangsmaterial dienender monokristalliner Halbleiterkörper 10, dessen spezifischer Widerstand etwa 1 bis 2 $\Omega \cdot cm$ und dessen Dicke 200 bis 400 µm beträgt. Es sei an dieser Stelle darauf hingewiesen, daß auf diesem Halbleiterkörper außer erfindungsgemäßen Schottky-Kontakten auch weitere aktive und passive Halbleiterbauelemente integriert werden können. Diese Bauelemente sind in dem dargestellten Ausschnitt nicht vorhanden. Auf die gereinigte Oberfläche 12 des Halbleiterkörpers 10 wird zunächst eine 0,5 µm dicke erste Maskierungsschicht

BU 978 003

aus Siliciumdioxid aufgebracht. Für das Aufbringen dieser ersten Maskierungsschicht sind verschiedene Verfahren anwendbar. In einem der Verfahren wird der Halbleiterkörper in einer Wasserdampf enthaltenden Sauerstoffatmosphäre auf etwa 1000 $^{o}$C erhitzt. Anschließend wird auf die erste Maskierungsschicht 13 aus Siliciumdioxid eine zweite Maskierungsschicht 14 aus Siliciumnitrid aufgebracht, die eine Dicke von etwa 50 nm aufweist. Die Dicke dieser Schicht kann in praktischen Fällen zwischen 25 nm und 250 nm liegen. Ein Verfahren zum Aufbringen dieser zweiten Maskierungsschicht 14 aus Siliciumnitrid besteht darin, daß in eine den Halbleiterkörper 10 enthaltende Reaktionskammer bei einer Temperatur von etwa 800 $^{o}$C ein Silan und Ammoniak enthaltendes Trägergas aus Wasserstoff geleitet wird. Dabei bildet sich auf der ersten Maskierungsschicht 13 aus Siliciumdioxid die zweite Maskierungsschicht 14 aus Siliciumnitrid. Auf die zweite Maskierungsschicht 14 wird eine weitere Schicht 15 aus Siliciumdioxid in einer Dicke von 300 nm aufgebracht. Diese Schicht 15 dient als Zwischenschicht, auf der in nachfolgenden Verfahrensschritten aufzubringende Photolackschichten gut haften und die außerdem als Ätzmaske für die zweite Maskierungsschicht 14 dienen kann. Diese Zwischenschicht 15 aus Siliciumdioxid wird vorzugsweise auf pyrolythischem Wege bei etwa 800 $^{o}$C niedergeschlagen.

Nach dem Aufbringen dieser genannten Schichten wird auf die Oberfläche der Zwischenschicht 15 eine Photolackschicht 16 aufgebracht. In bekannter Weise wird in dieser Photolackschicht 16 ein Fenser 18 freigelegt. Dieses Fenster 18 definiert den Bereich der darunterliegenden Zwischenschicht 13 und der ersten und zweiten Maskierungsschicht 14 und 15, der durch Ätzen entfernt werden muß, um den Bereich der Oberfläche 12 des Halbleiterkörpers 10 freizulegen, in dem der Schottky-Kontakt verwirklicht werden

BU 978 003

soll. Das Ätzen dieser Schichten im Bereich des Fensters 18 erfolgt nach in der integrierten Halbleitertechnik bekannten Weise. Das Fenster in der Zwischenschicht 15 aus Siliciumdioxid wird durch Tauchen in Flußsäure freigelegt. Der in diesem Fenster freigelegte Bereich der zweiten Maskierungsschicht 14 aus Siliciumnitrid wird mit Hilfe von heißer Phophorsäure entfernt. Bei diesem Prozeß wird auch der restliche Teil der nun nicht mehr benötigten Photolackschicht 16 entfernt. Nach dem Öffnen des Fensters in der zweiten Maskierungsschicht 14 ist der entsprechende Bereich in der ersten Maskierungsschicht 13 freigelegt, in der wiederum durch Tauchen in gepufferte Flußsäure ein entsprechendes Fenster geätzt wird. Dabei wird auch die restliche Zwischenschicht 15 aus Siliciumdioxid abgeätzt. Bei diesem letzten Ätzprozeß wird die erste Maskierungsschicht 13 nicht nur in Richtung auf die Oberfläche 12 des Halbleiterkörpers 10 geätzt, sondern auch in seitlicher Richtung, so daß eine Unterätzung der zweiten Maskierungsschicht 14 eintritt. Die Strecke der Unterätzung unterhalb der zweiten Maskierungsschicht 14 entspricht der Dicke der ersten Maskierungsschicht 13, d. h. also, weist die erste Maskierungsschicht 13 eine Dicke von 100 nm auf, so beträgt auch die Ausweitung des Fensters 18 im Bereich der ersten Maskierungsschicht 13 etwa 100 nm. Diese Unterätzung tritt ein, da die verwendete Ätzlösung im Bereich des Maskenfensters 18 in allen Richtungen auf die erste Maskierungsschicht einwirkt. Nach Öffnen des Maskenfensters in der ersten Maskierungsschicht 13 liegt ein Gebiet 12a der Oberfläche 12 des Halbleiterkörpers 10 frei. Die zweite Maskierungsschicht 14 aus Siliciumnitrid weist also ein kleineres Fenster auf als die erste Maskierungsschicht 13 aus Siliciumdioxid. Die nach den bisher beschriebenen Verfahrensschritten entstandene Struktur ist in Fig. 1B dargestellt.

0012220

Wie in Fig. 1C gezeigt, wird nunmehr im dem Maskenfenster in der ersten Maskierungsschicht 13 entsprechenden Bereich 12a eine dünne Siliciumdioxidschicht 19 aufgebracht. Die Dicke dieser Schicht liegt unter 10 nm. Da diese Siliciumschicht in einem Aufdampfprozeß aufgebracht wird, erstreckt sie sich auch unter den Bereich der überstehenden ersten Maskierungsschicht 14.

Auf dem Aufbringen der dünnen Siliciumdioxidschicht 19 wird eine diffusionshindernde Schicht 21 auf die Oberfläche der Gesamtstruktur aufgebracht. Beispielsweise verwendet man als Material für diese Schicht Molybdän oder andere schwer schmelzende Metalle in einer Dicke von beispielsweis 50 nm. Das Aufbringen dieser Schicht erfolgt durch einen senkrecht zur Oberfläche der Struktur gerichteten Aufdampfprozeß. Durch diesen gerichteten Aufdampfprozeß wird der unterhalb des vorstehenden Bereiches der zweiten Maskierungsschicht 14 liegende Bereich der Siliciumdioxidschicht 19 nicht beschichtet. Das bedeutet, daß innerhalb des Fensters 18 nur der durch das Maskenfenster in der zweiten Maskierungsschicht 14 begrenzte Bereich mit der diffusionshindernden Schicht 19 belegt wird. Die nach diesem Verfahrensschritt gebildete Struktur ist in Fig. 1D dargestellt. Es ist darauf hinzuweisen, daß die Dicke der Siliciumdioxidschicht 19 und die Dicke der diffusionshindernden Schicht 21 bzw. 21a zusammengenommen nicht die Dicke der ersten Maskierungsschicht 13 erreichen dürfen. Aufgrund dieser Dickenbeschränkung und aufgrund des überstehenden Randes der zweiten Maskierungsschicht bildet sich zwischen der diffusionshindernden Schicht 21a, dem inneren Rand des Fensters in der ersten Maskierungsschicht 13 und dem unteren Rand des überstehenden Teiles der zweiten Maskierungsschicht 14 ein Spalt 22.

BU 978 003

Nunmehr wird die Anordnung wieder in gepufferte Flußsäure getaucht, die durch den Spalt 22 gelangt und dort den zwischen dem äußeren Rand der diffusionshindernden Schicht 21a und dem inneren Rand des Fensters 18 in der ersten Maskierungsschicht 13 liegenden Teil der Siliciumdioxidschicht 19 abätzt. Da dieses Tauchätzen nur so lange fortgesezt wird, bis die dünne Siliciumdioxidschicht 19 abgeätzt ist, wird das Siliciumdioxid der ersten Maskierungsschicht 13 kaum angegriffen. Durch das Abätzen des ringförmigen Teils der Siliciumdioxidschicht 19 wird ein entsprechendes ringförmiges Gebiet 12b der Oberfläche 12 des Halbleiterkörpers 10 freigelegt. Die am Ende dieses Prozeßschrittes gebildete Struktur ist in Fig. 1E dargestellt.

Im nächsten Verfahrensschritt, der sich aus der Fig. 1F ergibt, erfolgt eine Störstellendiffusion aus der Gasphase, um im Bereich des ringförmigen Gebietes 12B die gewünschte Schutzringzone 23 in die Oberfläche des Halbleiterkörpers 10 einzubringen. Das zu verwendende Störstellenmaterial hängt vom jeweiligen Leitungstyp des Halbleiterkörpers 10 ab und kann beispielsweise aus Arsen, Phosphor oder Bor usw. bestehen. Bei dieser Diffusion wirken die zweite Maskierungsschicht 14, die erste Maskierungsschicht 13 und die diffusionshindernde Schicht 21a als Diffusionsmaske, so daß durch den Spalt 22 hindurch lediglich im ringförmigen Oberflächenbereich 12b die Schutzringzone 12b eindiffundiert wird.

Nach diesem Diffusionsschritt wird unter Verwendung eines geeigneten Ätzmittels die diffusionshindernde Schicht 21 abgeätzt. Anschließend wird die nunmehr freigelegte dünne Siliciumdioxidschicht 19 durch Tauchätzen entfernt.

Nach Entfernung der diffusionshindernden Schicht 21 und der dünnen Siliciumdioxidschicht 19 wird im Bereich des Fensters 18 eine Metallschicht 24 aufgebracht, die beispielsweise aus Aluminium besteht und eine Dicke von etwa 1 µm aufweist. Diese Metallschicht soll anschließend den angestrebten Schottky-Kontakt bilden. Das Aufbringen der Metallschicht 24 kann in üblicher Weise erfolgen, beispielsweise durch Aufdampfen. Die sich ergebende, in Fig. 1G dargestellte Struktur wird in neutraler Atmosphäre erhitzt, so daß eine Sinterung erfolgt. Dabei bildet sich der Schottky-Kontakt zwischen der Metallschicht 24 und dem Halbleiterkörper 10. Der Schottky-Kontakt ist genau auf die Schutzringzone 23 ausgerichtet, wobei diese Ausrichtung im Zuge des Herstellungsverfahrens automatisch erfolgt ist. Auf diese Weise ist außer dem Schottky-Kontakt selbst eine Schutzringzone entstanden, und zwar ohne zusätzlichen Flächenaufwand.

BU 978 003

PATENTANSPRÜCHE

1. Verfahren zur Herstellung eines Schottky-Kontakts mit Schutzringzone (22), die den Schottky-Kontakt umgibt und in die Oberfläche (12b) des diesen tragenden, dem entgegengesetzten Leitungstyp angehörenden Halbleiterkörpers (10) eingebracht ist, gekennzeichnet durch folgende Verfahrensschritte:

a) auf die Oberfläche (12) des Halbleiterkörpers (10) wird eine erste (13) und darüber eine zweite Maskierungsschicht (14) aufgebracht;

b) in der ersten Maskierungsschicht (13) wird ein erstes und in der zweiten Maskierungsschicht (14) ein zweites, auf das erste ausgerichtete Maskenfenster geöffnet, wobei das erste Maskenfenster größer als das zweite ist;

c) im Bereich des zweiten Maskenfensters wird eine diffusionshindernde Schicht (21a), die dünner als die erste Maskierungsschicht (13) ist, auf die Oberfläche (12) des Halbleiterkörpers (10) aufgebracht;

d) in den freiliegenden, ringförmigen Bereichen (12b) der Oberfläche des Halbleiterkörpers (10) zwischen äußerem Rand der diffusionshindernden Schicht (21a) und dem inneren Rand des ersten Maskenfensters wird die Schutzringzone (23) eindiffundiert;

e) im Bereich des zweiten Maskenfensters wird der Schottky-Kontakt verwirklicht.

BU 975 003

0012220

2.  Verfahren nach Anspruch 1, dadurch gekennzeichnet,
daß im Verfahrensschritt c) als diffusionshindernde
Schicht (21a) bereits das den Schottky-Kontakt bildende Metall aufgebracht wird.

3.  Verfahren nach Anspruch 1, dadurch gekennzeichnet,
daß die Verfahrensschritte c) bis e) derart ausgestaltet sind, daß im Bereich des ersten Maskenfensters
zunächst eine Isolationsschicht (19) und darüber im
Bereich des zweiten Maskenfensters die diffusionshindernde Schicht (21a) aufgebracht wird, wobei beide
Schichten zusammen dünner als die erste Maskierungsschicht (13) sind, daß unter Verwendung der ersten
und zweiten Maskierungsschicht (13, 14) und der
diffusionshindernden Schicht (21a) als Ätzmaske der
ringförmige Bereich der Isolationsschicht (19) zwischen dem äußeren Rand der diffusionshindernden
Schicht (21a) und dem inneren Rand des ersten Maskenfensters abgeätzt wird, daß in diesem Bereich die
Schutzringzone (23) eindiffundiert wird, daß der
restliche Teil der Isolationsschicht (19) mit der
diffusionshindernden Schicht (21a) abgeätzt wird und
daß im Bereich des zweiten Maskenfensters der Schottky-
Kontakt (24) aufgebracht wird.

4.  Verfahren nach einem der Ansprüche 1 bis 3,
dadurch gekennzeichnet,
daß der Halbleiterkörper (10) aus Silicium, die erste
Maskierungsschicht (13) aus Siliciumdioxid und die
zweite Maskierungsschicht (14) aus Siliciumnitrid
besteht.

5. Verfahren nach Anspruch 4, dadurch gekennzeichnet, daß die Isolationsschicht (19) aus Siliciumdioxid besteht.

6. Verfahren nach den Ansprüchen 1 bis 5, dadurch gekennzeichnet, daß die diffusionshindernde Schicht (21a) aus einem hochschmelzenden Metall besteht.

FIG. 1A

FIG. 1E

FIG. 1B

FIG. 1F

FIG. 1C

FIG. 1G

FIG. 1D

Europäisches
Patentamt

**EUROPÄISCHER RECHERCHENBERICHT**

0012220

Nummer der Anmeldung

EP 79 10 4373

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | NEUES AUS DER TECHNIK, Nr. 1, 1. Februar 1972, Würzburg,DE, "Herstellung von Halbleiter-Bauelementen mit schmalen Halbleiterzonen oder mit Halbleiterzonen in kleinem Abstand", Seite 1 <br><br> * Spalte 1; Spalte 2, Absatz 1; Figur 1 * <br><br> -- | 1,3-5 |
| X | IBM TECHNICAL DISCLOSURE BULLETIN, Band 21,Nr. 5, Oktober 1978, New York, US, K.D. BEYER: "Formation of SBD guard rings", Seite 1959 <br><br> * Seite 1959 * <br><br> -- | 1,3-5 |
| A | IBM TECHNICAL DISCLOSURE BULLETIN, Band 19, Nr. 11, April 1977, New York, US, R.A. UNIS: "Fabrication process for narrow line separation", Seiten 4089-4090 <br><br> * Seiten 4089-4090 * <br><br> -- | 1 |
| A | US - A - 4 026 740 (INTEL) <br><br> * Zusammenfassung; Figuren 5,7 * <br><br> ---- | 1 |

**KLASSIFIKATION DER ANMELDUNG (Int.Cl. 3)**

H 01 L 29/91

**RECHERCHIERTE SACHGEBIETE (Int. Cl. 3)**

H 01 L 29/91
21/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 08-02-1980 | PELSERS |

EPA form 1503.1  06.78